(19) Europäisches Patentamt
European Patent Office
Office européen des brevets

(11) **EP 1 994 417 B1**

(12) **EUROPÄISCHE PATENTSCHRIFT**

(45) Veröffentlichungstag und Bekanntmachung des Hinweises auf die Patenterteilung:
**09.10.2019 Patentblatt 2019/41**

(51) Int Cl.:
***G01R 15/00*** *(2006.01)*

(21) Anmeldenummer: **07726797.9**

(22) Anmeldetag: **12.03.2007**

(86) Internationale Anmeldenummer:
**PCT/EP2007/052287**

(87) Internationale Veröffentlichungsnummer:
**WO 2007/104735 (20.09.2007 Gazette 2007/38)**

(54) **VORRICHTUNG UND VERFAHREN ZUR MESSUNG EINER ERSTEN SPANNUNG UND EINER ZWEITEN SPANNUNG MIT EINEM DIFFERENZSPANNUNGSMESSER**

DEVICE AND METHOD FOR MEASURING A FIRST VOLTAGE AND A SECOND VOLTAGE BY MEANS OF A DIFFERENTIAL VOLTMETER

DISPOSITIF POUR MESURER UNE PREMIÈRE TENSION ET UNE SECONDE TENSION AU MOYEN D'UN VOLTMÈTRE DIFFÉRENTIEL

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **14.03.2006 DE 102006011715**

(43) Veröffentlichungstag der Anmeldung:
**26.11.2008 Patentblatt 2008/48**

(73) Patentinhaber: **Eaton Intelligent Power Limited Dublin 4 (IE)**

(72) Erfinder: **MEID, Wolfgang**
**56218 Mülheim-Kärlich (DE)**

(56) Entgegenhaltungen:
**EP-A- 1 130 405     EP-A1- 0 098 321**
**EP-A2- 1 384 652     US-A- 5 579 194**
**US-B1- 6 236 215**

**Beschreibung**

Die vorliegende Erfindung betrifft eine Vorrichtung und ein Verfahren zur Messung einer ersten Spannung und einer zweiten Spannung mit einem Differenzspannungsmesser.

STAND DER TECHNIK

Das Messen mehrerer Spannungen ist in vielen Vorrichtungen erforderlich. Diese Spannungsmessung von mehreren Spannungen kann z.B. durch einen Mikrocontroller erfolgen, der für jede der zu messenden Spannung einen Spannungsmesser aufweist.

So müssen beispielsweise bei der Realisierung eines elektronischen Motorschutzschalters für einen DreiphasenElektromotor die drei Phasenströme des Motors erfasst werden, wozu drei unabhängige Spannungsmesser in einem Mikrocontroller verwendet werden können. Für jede weitere zu erfassende Spannung wäre ein weiterer Spannungsmesser in dem Mikrocontroller nötig. Mikrocontroller mit mehr als drei Spannungsmessern sind jedoch kostenintensiver und weisen eine höhere Baugröße als Mikrocontroller mit nur drei Spannungsmessern auf.

Aus der europäischen Patentanmeldung EP 1 130 405 A1 ist ein Verfahren zum Messen von Batteriespannungen bekannt, wobei eine Vielzahl von Batterien in Reihe geschaltet sind. Die einzelnen über den Batterien anfallenden Spannungen werden durch einen Differenzverstärker und zwei Multiplexer gemessen, wobei die Multiplexer für einen Messvorgang einer Spannung einer Batterie zwei dieser Batterie zugeordnete Knotenpunkte mit den beiden Eingängen des Differenzverstärkers verbinden.

AUFGABENSTELLUNG

Der Erfindung liegt davon ausgehend die Aufgabe zugrunde, ein Verfahren bzw. eine Vorrichtung zur Spannungsmessung dahingehend zu entwickeln, dass die Messung einer ersten Spannung und die Messung einer zweiten Spannung mit nur einem Spannungsmesser durchgeführt werden kann.

Diese Aufgabe wird bei einem Verfahren der eingangs genannten Art dadurch gelöst, dass ein Verfahren zur Messung einer ersten Spannung und einer zweiten Spannung mit einem Differenzspannungsmesser bereitgestellt wird, wobei der Differenzspannungsmesser einen ersten Eingang, und einen zweiten Eingang umfasst, und wobei die erste Spannung an einem Ausgang einer ersten Detektionseinheit anliegt, und diese erste Detektionseinheit zum Erfassen eines ersten Stroms dient, welcher einem Elektromotor, insbesondere einem Wechselstrommotor, zugeführt wird, so dass die an dem Ausgang der ersten Detektionseinheit anliegende Spannung vom erfassten ersten Strom abhängt; und wobei ferner der Ausgang der ersten Detektionseinheit mit dem ersten Eingang des Differenzspannungsmessers verbunden ist und hierdurch die erste Spannung an den ersten Eingang des Differenzspanungsmessers angelegt ist, wobei das Verfahren die folgenden Schritte umfasst: Anlegen eines bekannten Spannungspotentials an den zweiten Eingang des Differenzspannungsmessers; Messen einer ersten Differenzspannung; Bestimmen der ersten Spannung aus der gemessenen ersten Differenzspannung und dem bekannten Spannungspotential; Anlegen der zweiten Spannung an den zweiten Eingang des Differenzspannungsmessers; Messen einer zweiten Differenzspannung während die erste Spannung am ersten Eingang des Differenzspannungsmessers angelegt ist; und Bestimmen der zweiten Spannung aus der gemessenen zweiten Differenzspannung und der vorher bestimmten ersten Spannung.

Der Differenzspannungsmesser kann so ausgeführt sein, dass er entweder die Differenz zwischen der Spannung am zweiten Eingang und der Spannung am ersten Eingang misst, oder umgekehrt die Differenz zwischen der Spannung am ersten Eingang und der Spannung am zweiten Eingang. Im folgenden sei ohne Einschränkung angenommen, dass der Differenzspannungsmesser die Differenz zwischen der Spannung am zweite Eingang und der Spannung am ersten Eingang messe, d.h. der erste Eingang ist der negative Eingang des Differenzspannungsmesser und der zweite Eingang ist der positive Eingang des Differenzspannungsmessers.

Sei die erste gemessene Differenzspannung $U_{D,1}$ und das bekannte Spannungspotential $U_B$, so kann die erste Spannung wie folgt aus der ersten gemessenen Differenzspannung $U_{D,1}$ und dem bekannten Spannungspotential $U_B$ bestimmt werden:

$$U_1 = U_B - U_{D,1}$$

Basierend auf der ersten bestimmten Spannung $U_1$ und der zweiten gemessenen Differenzspannung $U_{D,2}$ kann mit $U_2 = U_{D,2} + U_1$ die zweite Spannung $U_2$ bestimmt werden.

Dieses Messverfahren zeigt den Vorteil, dass mit nur einem Differenzspannungsmesser zwei Spannungen, d.h. die erste Spannung und die zweite Spannung, gemessen werden können. Das bekannte Spannungspotential $U_B$ kann beispielsweise Masse sein, d.h. $U_B=0$, so dass der Betrag der gemessene ersten Differenzspannung dem Betrag der zu messenden ersten Spannung entspricht und folglich der Schritt der Bestimmung der ersten Spannung aus der gemessenen ersten Differenzspannung und dem bekannten Spannungspotential nicht mehr ausgeführt werden muss bzw. stark vereinfacht wird, da keine Subtraktion oder Addition benötigt wird. Dies kann insbesondere dann vorteilhaft sein, wenn die erste Spannung negativ ist, da hierbei die erste gemessene Differenzspannung ein positives Vorzeichen aufweist und dem Betrag der ersten Spannung entspricht.

Somit kann mit Hilfe des erfindungsgemäßen Messverfahrens auf eine einfache Weise eine negative erste Spannung gemessen werden, wohingegen bei der Verwendung von AD-Wandlern ohne Differenzeingang zur Spannungsmessung die zu messende negative Spannung vor der Messung mit Hilfe einer aufwändigen Operationsverstärkerschaltung in eine positive Spannung konvertiert werden müsste.

Ferner ist auch die Reihenfolge der Schritte des erfindungsgemäßen Verfahrens zur Spannungsmessung austauschbar. So kann beispielsweise auch zuerst die zweite Spannung an den zweiten Eingang des Differenzspannungsmessers angelegt werden, dann die zweite Differenzspannung gemessen werden, und nachfolgend erst das bekannte Spannungspotential an den zweiten Eingang des Differenzspannungsmessers angelegt werden und die erste Differenzspannung gemessen werden.

Des Weiteren können beispielsweise auch zunächst die erste Differenzspannung und die zweite Differenzspannung gemessen werden, und nachfolgend erst die zu messende erste Spannung und zweite Spannung bestimmt werden.

Das erfindungsgemäße Verfahren zur Messung der ersten Spannung und der zweiten Spannung kann beispielsweise auf einem Mikrocontroller durchgeführt werden, oder auch z.B. auf einem digitalen Signalprozessor, oder auch in Form von Software auf einem Computer.

Der Differenzspannungsmesser kann sowohl analog als auch digital realisiert werden. Beispielsweise kann der Differenzspannungsmesser durch einen Sigma Delta AD Wandler realisiert werden.

Ein weiterer Vorteil des erfindungsgemäßen Messverfahrens liegt darin, dass der Messbereich des Differenzspannungsmessers weitgehend ausgenutzt werden kann.

Eine Ausgestaltung der Erfindung sieht vor, dass nach dem Messen der zweiten Differenzspannung geprüft wird, ob die zweite Differenzspannung einen vorbestimmtem Grenzwert überschreitet, und das Messverfahren bei Überschreitung des vorbestimmten Grenzwertes wieder von vorne beginnt, wobei das Messverfahren so lange wiederholt wird, bis die zweite gemessene Differenzspannung den vorbestimmten Grenzwert nicht überschreitet, und erst dann die zweite Spannung aus der gemessenen zweiten Differenzspannung und der vorher bestimmten ersten Spannung bestimmt wird.

Mit Hilfe dieses Überprüfens, ob die gemessene zweite Differenzspannung einen vorbestimmten Grenzwert überschreitet, kann beispielsweise festgestellt werden, ob die zweite gemessene Differenzspannung im zulässigen Messbereich des Differenzspannungsmessers liegt, wobei dann der Grenzwert in Abhängigkeit des vom Differenzspannungsmesser maximal zu erfassenden Messbereichs zu wählen ist. Liegt eine Überschreitung des Grenzwertes vor, d.h. liegt die gemessene zweite Differenzspannung außerhalb des zulässigen Messbereiches, so wird die gesamte Spannungsmessung wiederholt, d.h. es wird zunächst das bekannte Spannungspotential an den zweiten Eingang des Differenzspannungsmessers angelegt und die erste Differenzspannung gemessen, und dann die zweite Spannung an den zweiten Eingang des Differenzspannungsmessers gelegt und die zweite Differenzspannung gemessen. Der Messvorgang wird so lange wiederholt, bis die zweite gemessene Differenzspannung den vorbestimmten Grenzwert nicht mehr überschreitet. Erst dann erfolgt die Bestimmung der zweiten Spannung aus der gemessenen zweiten Differenzspannung der vorher bestimmten ersten Spannung.

Ferner kann auch zusätzlich zu dieser Überprüfung, ob die zweite gemessene Differenzspannung einen vorbestimmten Grenzwert überschreitet, auch bereits nach Messung der ersten Differenzspannung geprüft werden, ob die erste gemessene Differenzspannung einen vorbestimmten Grenzwert überschreitet, und bei Überschreitung der Messvorgang erneut gestartet werden. Somit kann der Messvorgang direkt dann wiederholt werden, wenn bereits die erste gemessene Differenzspannung außerhalb des zulässigen Messbereiches des Differenzspanunngsmessers liegt.

Eine Ausgestaltung der Erfindung sieht vor, dass eine Schalteinheit an den zweiten Eingang das Differenzspannungsmesser angeschlossen ist, derart, dass die Schalteinheit in einem ersten Zustand das bekannte Spannungspotential an den zweiten Eingang des Differenzspannungsmessers schaltet, und dass die Schalteinheit in einem zweiten Zustand die zweite Spannung an den zweiten Eingang des Differenzspannungsmesser schaltet; und wobei die Schalteinheit zur Messung der ersten Differenzspannung in den ersten Zustand angesteuert wird, und nachfolgend die Schalteinheit zur Messung der zweiten Differenzspannung in den zweiten Zustand angesteuert wird.

Diese Schalteinheit kann beispielsweise durch mindestens ein Relais und/oder mindestens einen Transistor realisiert werden.

Eine Ausgestaltung der Erfindung sieht vor, dass der Differenzspannungsmesser in einem Mikrocontroller angeordnet ist, wobei das Messverfahren durch den Mikrocontroller ausgeführt wird, und insbesondere die Schalteinheit durch den Mikrocontroller gesteuert wird.

Der Mikrocontroller kann somit direkt die gemessene erste Differenzspannung und die gemessene zweite Differenzspannung vom Differenzspannungsmesser auslesen und die Verarbeitungsschritte des erfindungsgemäßen Messverfahrens ausführen. Hierbei steuert die Mikrocontroller die Schalteinheit zunächst in den ersten Zustand, liest die gemessene erste Differenzspannung am Differenzspannungsmesser aus und berechnet aus der gemessenen ersten Differenzspannung und dem bekannten Spannungspotential die erste Spannung. Nachfolgend schaltet der Mikrocontroller die Schalteinheit in den zweiten Zustand und liest die gemessene zweite Differenzspannung am Differenzspannungsmesser aus, und berechnet dann die zweite Spannung aus der gemessenen zweiten Differenzspannung und der bereits bestimmten ersten Spannung. Die so bestimmte erste Spannung und zweite Spannung kann der Mikrocontroller intern für weitere Verarbeitung verwenden und/oder an einem Ausgang ausgeben.

Ferner kann der Mikrocontroller auch die zuvor beschriebene Prüfung der Grenzwertüberschreitung der zweiten gemessenen Spannung ausführen, und bei Überschreiten des vorbestimmten Grenzwertes den Messvorgang erneut beginnen, so lange, bis keine Grenzwertüberschreitung der zweiten gemessenen Spannung vorliegt. Des Weiteren kann der Mikrocontroller auch für die zuvor beschriebene Prüfung der Grenzwertüberschreitung der ersten gemessenen Spannung und dem daraus eventuell resultierenden Neustart des Messvorgangs verwendet werden.

Eine Ausgestaltung der Erfindung sieht vor, dass der Differenzspannungsmesser ein Sigma Delta AD Wandler ist.

Eine Ausgestaltung der Erfindung sieht vor, dass die Schalteinheit einen Transistor umfasst.

Der Transistor kann beispielsweise durch einen Feldeffekttransistor realisiert werden, wobei entweder ein Sperrschichtfet, ein Depletion-Mosfet oder ein Enhancement-Mosfet verwendet werden kann. Der Feldeffekttransistor kann sowohl durch einen n-Kanal oder einen p-Kanaltyp realisiert werden. Ferner kann auch ein Bipolartransistor für die Schalteinheit verwendet werden, welcher entweder ein npn- oder ein pnp-Typ sein kann. Darüberhinaus kann die Schalteinheit auch mehr als einen Transistor umfassen.

Die o.g. Aufgabe der Erfindung wird gelöst durch eine Vorrichtung zur Messung einer ersten Spannung und einer zweiten Spannung umfassend eine Schalteinheit und einen Mikrocontroller, der einen Differenzspannungsmesser enthält; wobei die erste Spannung an einem ersten Eingang des Differenzspannungsmessers anliegt; und wobei die Schalteinheit an den zweiten Eingang des Differenzspannungsmesser angeschlossen ist, derart, dass die Schalteinheit in einem ersten Zustand ein bekanntes Spannungspotential an den zweiten Eingang des Differenzspannungsmessers schaltet, und dass die Schalteinheit in einem zweiten Zustand die zweite Spannung an den zweiten Eingang des Differenzspannungsmesser schaltet während die erste Spannung am ersten Eingang des Differenzspannungsmessers anliegt; wobei die Vorrichtung eine erste Detektionseinheit umfasst, und diese erste Detektionseinheit zum Erfassen eines ersten Stroms dient, welcher einem Elektromotor, insbesondere einem Wechselstrommotor, zugeführt wird, so dass die an einem Ausgang der ersten Detektionseinheit anliegende Spannung vom erfassten ersten Strom abhängt, wobei die an dem Ausgang der ersten Detektionseinheit anliegende Spannung die erste Spannung darstellt, und wobei ferner dieser Ausgang mit dem ersten Eingang des Differenzspannungsmessers verbunden ist; und wobei der Mikrocontroller die folgenden Schritte ausführt: Ansteuern der Schalteinheit in den ersten Zustand; Einlesen einer vom Differenzspannungsmesser gemessenen ersten Differenzspannung; Bestimmen der ersten Spannung aus der gemessenen ersten Differenzspannung und dem bekannten, vorzugsweise durch das Massepotential gebildeten Spannungspotential; Ansteuern der Schalteinheit in den zweiten Zustand; Einlesen einer vom Differenzspannungsmesser gemessenen zweiten Differenzspannung; und Bestimmen der zweiten Spannung aus der gemessenen zweiten Differenzspannung und der vorher bestimmten ersten Spannung bestimmt.

Für diese erfindungsgemäße Vorrichtung zur Messung einer ersten Spannung und einer zweiten Spannung gelten die zuvor beschriebenen Ausführungen des Verfahrens zur Messung einer ersten Spannung und einer zweiten Spannung gleichermaßen. Der Mikrocontroller übernimmt hierbei die Steuerung der Messung und bestimmt die erste Spannung und die zweite Spannung. Eine Ausgestaltung der Erfindung sieht vor, dass der Mikrocontroller nach dem Messen der zweiten Differenzspannung prüft, ob die zweite Differenzspannung einen vorbestimmtem Grenzwert überschreitet, und der Mikrocontroller die Messung bei Überschreiten des vorbestimmten Grenzwertes wieder von vorne beginnt, wobei der Mikrocontroller die Messung so lange wiederholt, bis die zweite Differenzspannung den vorbestimmten Grenzwert nicht überschreitet, und dann erst dann der Mikrocontroller die zweite Spannung aus der gemessenen zweiten Differenzspannung und der vorher bestimmten ersten Spannung bestimmt.

Für diese Ausführungsform betreffend des Prüfens einer Grenzwertüberschreitung der gemessenen Differenzspannung gelten die zuvor bei den Verfahrensausführungen beschriebenen Abwandlungen dieser Ausführungsform analog.

Eine Ausgestaltung der Erfindung sieht vor, dass der erste Eingang des Differenzspannungsmessers der negative Eingang des Differenzspannungsmessers ist, und der zweite Eingang des Differenzspannungsmessers der positive Eingang des Differenzspannungsmessers ist.

Somit misst der Differenzspannungsmesser die Differenz zwischen der zweiten Spannung und der ersten Spannung.

Diese Ausgestaltung der Erfindung ist insbesondere dann vorteilhaft, wenn die zu messende erste Spannung negativ ist und das bekannte Spannungspotential Masse ist, da hierbei die erste gemessene Differenzspannung direkt dem Betrag der negativen ersten Spannung entspricht. Somit entfallen für die Messung der negativen ersten Spannung aufwändige Konverterschaltungen, welche z.B. durch Operationsverstärker realisiert werden müssten.

Eine Ausgestaltung der Erfindung sieht vor, dass zwischen der Schalteinheit und dem zweiten Eingang des Differenzspannungsmessers ein Entkopplungsglied platziert ist.

Dieses Entkopplungsglied dient zur Entkopplung des zweiten Eingangs des Differenzspannungsmesser von der Schalteinheit. Beispielsweise kann dieses Entkopplungsglied durch einen Widerstand realisiert werden.

Eine Ausgestaltung der Erfindung sieht vor, dass der Mikrocontroller mindestens einen weiteren Spannungsmesser umfasst.

Somit kann neben der ersten Spannung und der zweiten Spannung mindestens eine weitere Spannung gemessen werden, und der Mikrocontroller kann diese eine weitere Spannung beispielsweise für weitere Verarbeitung verwenden. Dieser mindestens eine weitere Spannungsmesser kann z.B. durch einen AD-Wandler mit nur einem Eingang realisiert werden, oder durch einen Differenzspannungsmesser, der z.B. einen Sigma Delta AD-Wandler darstellen kann. Es können auch AD-Wandler, welche einen Eingang aufweisen, mit Sigma Delta AD-Wandlern kombiniert werden.

Der Elektromotor kann entweder ein Gleichstrommotor oder ein Wechselstrommotor sein, wobei der Wechselstrommotor ein einphasiger Wechselstrommotor aber auch ein mehrphasiger Wechselstrommotor sein kann.

Wird der Elektromotor beispielsweise durch einen Gleichstrommotor realisiert, und ist somit auch der zugeführte erste Strom ein Gleichstrom, so kann die erste Detektionseinheit beispielsweise ein Widerstand sein, der sich in der Stromzuleitung zum Motor befindet, so dass der erste Strom durch den Widerstand fliesst und die am Widerstand abfallende Spannung am Ausgang der ersten Detektionseinheit anliegt; ferner kann die erste Detektionseinheit beispielsweise durch einen Magnetfeldwandler realisiert werden, so dass am Ausgang der ersten Detektionseinheit eine Spannung proportional zum gemessenen Magnetfeld und damit zum ersten Strom anliegt, wobei dieser Magnetfeldwandler beispielsweise durch einen Hallwandler realisiert werden kann.

Wird der Elektromotor beispielsweise durch einen Wechselstrommotor realisiert, so kann die erste Detektionseinheit beispielsweise ein induktiver Stromwandler sein, wie z.B. ein Transformator, der primärseitig vom zu erfassenden ersten Strom durchflossen wird, und auf dessen Sekundärseite der transformierte erste Strom in die am Ausgang der ersten Detektionseinheit anliegende Spannung umgewandelt wird. Diese Umwandlung kann beispielsweise durch einen Shunt-Widerstand erfolgen.

Eine Ausgestaltung der Erfindung sieht vor, dass die zweite Spannung an einem Kondensator anliegt, und der Kondensator mit der Schalteinheit verbunden ist, und wobei der Kondensator ein thermisches Gedächtnis für vorhergehende thermische Abschaltungen des Elektromotors darstellt.

Der als thermisches Gedächtnis verwendete Kondensator kann beispielsweise durch die am Kondensator anliegende Spannung die Erwärmung des Elektromotors während des normalen Betriebs und während einer Überlastungsphase nachbilden. Hierbei kann z.B. permanent die Wärmebilanz des Elektromotors gespeichert werden, so dass nach einer thermischen Abschaltung des Motors der thermische Zustand des Motors bekannt ist. Nach einer thermischen Abschaltung liegt damit an dem Kondensator eine dem thermischen Zustand des Elektromotors zugeordnete Spannung an, wobei nachfolgend der Kondensator nach einer vordefinierten Charakteristik entladen wird, so dass sich die Spannung am Kondensator verringert. Das Entladen kann beispielsweise über einen Widerstand erfolgen, wobei der Kondensator und der Widerstand die vordefinierte Entladecharakteristik definieren. Der Mikrocontroller kann die zweite Spannung über die erfindungsgemäße Messvorrichtung erfassen und beispielsweise einen erneuten Start des abgeschalteten Motors erst dann zulassen, wenn die zweite Spannung unter einen vordefinierten Pegel fällt, womit z.B. verhindert wird, dass der Motor nach einer vorhergehenden thermischen Abschaltung wieder zu schnell eingeschaltet wird und hierdurch Schaden nimmt. Damit kann der als thermisches Gedächtnis wirkende Kondensator beispielsweise das Bimetall ersetzen, welches in einem Motorschutzschalter zum Schutz des Elektromotors nach einer thermischen Abschaltung verwendet wird.

Eine Ausgestaltung der Erfindung sieht vor, dass ein Operationsverstärker zwischen dem Kondensator und der Schalteinheit platziert ist.

Der Operationsverstärker kann dazu dienen, dass der Kondensator nicht über die Schalteinheit entladen wird.

Eine Ausgestaltung der Erfindung sieht vor, dass zwischen dem Ausgang der ersten Detektionseinheit und dem ersten Eingang des Differenzspannungsmessers eine Filtereinheit platziert ist.

Diese Filtereinheit kann z.B. eine Tiefpasscharakteristik aufweisen, um hochfrequente Anteile der Spannung am Ausgang der Detektionseinheit zu unterdrücken und somit die Messgenauigkeit zu erhöhen. So kann diese Filtereinheit z.B. durch eine Viertorschaltung realisiert werden, bei der am Eingang und am Ausgang jeweils ein Kondensator gegen Masse geschaltet ist, und zwischen dem Ein- und dem Ausgang des Viertors ein Widerstand geschaltet ist.

Eine Ausgestaltung der Erfindung sieht vor, dass der Elektromotor ein Wechselstrommotor ist, und der erste Strom einen ersten Phasenstrom darstellt.

Der Elektromotor kann sowohl ein Einphasenwechselstrommotor sein, dem dann genau ein Phasenstrom zugeführt wird, er kann allerdings auch ein Mehrphasenwechselstrommotor sein, wie z.B. ein Dreiphasenwechselstrommotor.

Eine Ausgestaltung der Erfindung sieht vor, dass die erste Detektionseinheit folgende Mittel umfasst: Einen Stromwandler, durch dessen Primärseite der zu erfassende Phasenstrom fließt; und einen Gleichrichter, welcher an dem sekundärseitigen Ausgang des Stromwandlers angeschlossen ist zum Gleichrichten des transformierten Phasenstroms; und einen Widerstand, der zwischen dem Gleichrichter und einem Massepunkt angeschlossen ist, derart, dass der transformierte und gleichgerichtete Phasenstrom durch den Widerstand fließt und über dem Widerstand eine Spannung abfällt, und diese Spannung an dem Ausgang der Detektionseinheit anliegt.

Der Stromwandler kann z.B. auf verschiedene Nennstrombereiche einstellbar sein, so dass sich sekundärseitig unabhängig vom absoluten Nennstrombereich des jeweiligen Elektromotors ein konstanter transformierter Strombereich ergibt. Die Einstellung des Stromwandlers auf den jeweiligen Nennstrombereich in Abhängigkeit des Elektromotors kann z.B. durch das Wicklungsverhältnis zwischen Primär- und Sekundärseite realisiert werden.

Der Gleichrichter kann z.B. durch einen Einweggleichrichter realisiert werden, oder aber auch durch einen Mehrwegegleichrichter.

Der Widerstand kann ferner derart an den Gleichrichter angeschlossen sein, dass über dem ersten Widerstand eine negative Spannung gegen Masse abfällt.

Eine Ausgestaltung der Erfindung sieht vor, dass der Gleichrichter ein Brückengleichrichter ist, und ein zweiter Ausgang des Brückengleichrichters die Versorgungsspannung erzeugt.

Eine Ausgestaltung der Erfindung sieht vor, dass dem Elektromotor mindestens ein weiterer Phasenstrom zugeführt wird, und jedem des mindestens einen weiteren Phasenstroms jeweils eine weitere Detektionseinheit und jeweils ein im Mikrocontroller angeordneter Spannungsmesser zugeordnet ist, wobei jede dieser mindestens einen weiteren Detektionseinheit der ersten Detektionseinheit entspricht, so dass jeweils am Ausgang dieser mindestens einen weiteren Detektionseinheit eine Spannung anliegt, welche vom jeweils zugeordneten und erfassten Phasenstrom abhängt; und wobei ferner jeder Ausgang dieser mindestens einen weiteren Detektionseinheit mit einem ersten Eingang des jeweils zugeordneten Spannungsmessers verbunden ist.

Gemäß dieser Ausgestaltung der Erfindung ist der Elektromotor ein Mehrphasenwechselstrommotor, wie z.B. ein Dreiphasenwechselstrommotor. Jeder einzelne der dem Motor zugeführten Phasenströme wird durch eine separate Detektionseinheit erfasst, die vom Aufbau der vorher beschrieben ersten Detektionseinheit entspricht. Somit gelten alle vorher beschrieben Ausgestaltungen der ersten Detektionseinheit auch für jede der mindestens einen weiteren Detektionseinheit. Somit kann jeder der dem Elektromotor zugeführte Phasenstrom durch die jeweils zugeordnete Detektionseinheit erfasst werden, wobei jeder dieser Detektionseinheiten die dem detektierten Phasenstrom entsprechende Ausgangsspannung dem Mikrocontroller zur Spannungsmessung zuführt. Der Mikrocontroller besitzt hierzu neben dem Differenzspannungsmesser mindestens einen weiteren Spannungsmesser. Dieser mindestens eine weitere Spannungsmesser kann durch einen AD-Wandler mit einem Eingang realisiert werden, jedoch kann dieser mindestens eine weitere Spannungsmesser auch durch einen Differenzspannungsmesser ausgeführt werden, wie z.B. ein Sigma Delta AD Wandler. Wird ein solcher Differenzspannungsmesser für den mindestens einen weiteren Spannungsmesser verwendet, so kann der erste Eingang des Differenzspannungsmesser, an dem die Ausgangsspannung der zugeordneten Detektionseinheit anliegt, der negative Eingang des Differenzspannungsmessers sein, während der positive Eingang des Differenzspannungsmesser mit Masse verbunden ist, wobei zwischen diesem positiven Eingang und der Masse ein Widerstand geschaltet sein kann.

Eine Ausgestaltung der Erfindung sieht vor, dass zwischen mindestens einem Ausgang der mindestens einen weiteren Detektionseinheit und dem ersten Eingang des jeweils zugeordneten Spannungsmesser eine Filtereinheit platziert ist.

Für diese Filtereinheit gelten die zuvor ausgeführten Ausgestaltungen der Filtereinheit zwischen der ersten Detektionseinheit und dem zugehörigen Differenzspannungsmessers.

Eine Ausgestaltung der Erfindung sieht vor, dass mindestens einer des mindestens einen weiteren Spannungsmessers ein Sigma Delta AD Wandler ist, und ein zweiter Eingang dieses mindestens einen Sigma Delta AD Wandlers mit Masse verbunden ist und wobei der erste Eingang des mindestens einen Sigma AD Wandlers der negative Eingang ist, und der zweite Eingang des mindestens einen Sigma Delta AD Wandlers der positive Eingang ist. Zwischen dem positiven Eingang dieses mindestens einen Sigma Delta AD Wandlers und der Masse kann ein Widerstand geschaltet sein.

Eine Ausgestaltung der Erfindung sieht vor, dass der Mikrocontroller und die mindestens eine Detektionseinheit in einem Motorschutzschalter angeordnet sind.

Der Motorschutzschalter dient zum Schutz eines Elektromotor, beispielsweise vor einer Überlast, wobei der Mikrocontroller zur Überwachung von mindestens einem dem Elektromotor zugeführten Strom verwendet wird, wobei dieser mindestens eine dem Elektromotor zugeführte Strom durch die mindestens eine Detektionseinheit erfasst wird. Jede der mindestens einen Detektionseinheit gibt eine dem jeweils erfassten Strom proportionale Spannung aus, welche von jeweils einem Spannungsmesser innerhalb des Mikrocontrollers erfasst wird. Aufgrund der mindestens einen erfassten Spannung kann der Mikrocontroller prüfen, ob der mindestens eine dem Elektromotor zugeführte Strom einen vorbestimmten Grenzwert überschreitet, und dann eine Überlastabschaltung des Elektromotors ausführen.

Somit kann das erfindungsgemäße Verfahren und die Vorrichtung zur Messung einer ersten Spannung und einer zweiten Spannung zur Realisierung eines elektronischen Motorschutzschalters verwendet werden. Bei einem Dreiphasen-Wechselstrommotor kann beispielsweise mit einem Mikrocontroller, welcher drei Differenzspannungsmesser besitzt, jeder er drei dem Motor zugeführten Phasenströme mit jeweils einem Differenzspannungsmesser erfasst werden, und ferner kann mit einem der drei Differenzspannungsmesser mit Hilfe der vorliegenden Erfindung parallel auch eine zweite Spannung, die z.B. an dem als thermisches Gedächtnis wirkenden Kondensator anliegt, erfasst werden. Somit kann der Mikrocontroller mit nur drei Differenzspannungsmesser vier Spannungen erfassen, so dass eine kostengünstige Realisierung des elektronischen Motorschutzschalters ermöglicht wird.

Eine Ausgestaltung der Erfindung sieht vor, dass das bekannte Spannungspotential Masse ist.

Ausführungsbeispiele

Die Erfindung wird im folgenden anhand von Zeichnungen, die zwei Ausführungsbeispiele zeigen, näher erläutert.

Dabei zeigen:

Fig. 1: Eine Ausführungsform einer erfindungsgemäßen Vorrichtung zur Messung einer ersten Spannung und einer zweiten Spannung entsprechend Anspruch 5, wobei die Fig. 1 die erste Detektionseinheit und den Elektromotor nicht zeigt.

Fig. 2: Ein Flussdiagramm eines erfindungsgemäßen Verfahrens zur Messung einer ersten Spannung und einer zweiten Spannung entsprechend Anspruch 1.

Fig. 3: Eine weitere Ausführungsform einer erfindungsgemäßen Vorrichtung zur Messung einer ersten Spannung und einer zweiten Spannung.

Fig. 4: Ein exemplarisches Spannungsdiagramm zur Visualisierung der erfindungsgemäßen wiederholten Spannungsmessung bei der weiteren Ausführungsform.

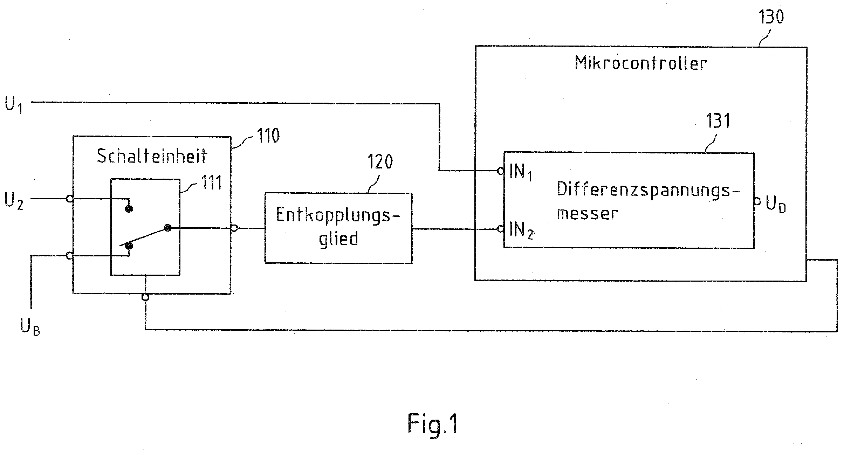

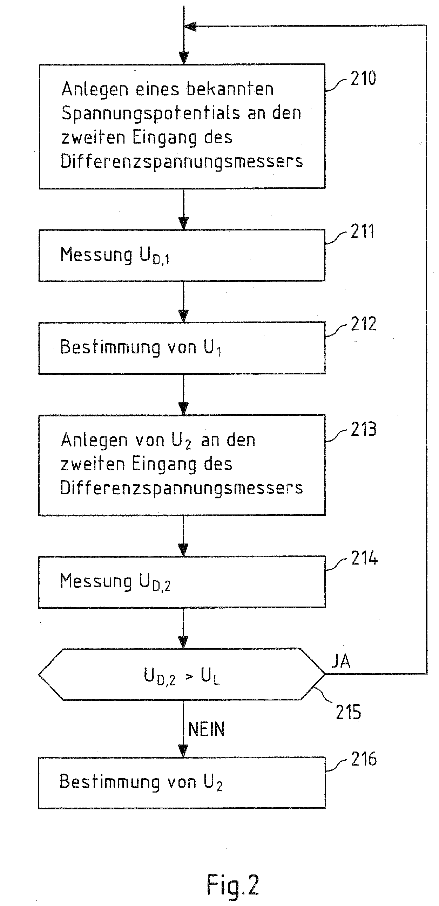

Das in Fig. 1 gezeigte Blockschaltbild zeigt ein Ausführungsbeispiel einer Vorrichtung zur Messung einer ersten Spannung $U_1$ und einer zweiten Spannung $U_2$ entsprechend Anspruch 1, wobei die Fig. 1 die erste Detektionseinheit und den Elektromotor nicht zeigt. Die erfindungsgemäße Spannungsmessung wird im Folgenden unter Einbeziehung des in Fig. 2 dargestellten Flussdiagramms, in welcher die Schritte des erfindungsgemäßen Messverfahrens dargestellt sind, erläutert. Die in Fig. 2 dargestellten Verfahrenschritte können beispielsweise auf einem Mikrocontroller, aber auch z.B. auf einen DSP ausgeführt werden.

Die in Fig. 1 dargestellte Vorrichtung umfasst einen Mikrocontroller 130, welcher einen Differenzspannungsmesser 131 mit einem ersten Eingang $IN_1$ und einen zweiten Eingang $IN_2$ beinhaltet. Die erste zu messende Spannung $U_1$ liegt am ersten Eingang $IN_1$ Differenzspannungsmessers 131 an. Der zweite Eingang $IN_2$ des Differenzspannungsmesser 131 ist über ein Entkopplungsglied 120 mit einer Schalteinheit 110 verbunden. Die Schalteinheit schaltet durch ein Schaltelement 111, welches beispielsweise durch ein Relais oder einen Transistor realisiert werden kann, entweder die zu messende zweite Spannung $U_2$ an den zweiten Eingang des Differenzspannungsmessers 131, oder eine bekannte Spannung $U_B$ an den zweiten Eingang des Differenzspannungsmessers 131. Die Schalteinheit 110 ist ferner über eine Steuerleitung mit dem Mikrocontroller 130 verbunden, so dass der Mikrocontroller mit Hilfe der Schalteinheit entweder die zu messende Spannung $U_2$ oder die bekannte Spannung $U_B$ an den zweiten Eingang $IN_2$ des Differenzspannungsmessers 131 schalten kann.

Die Figuren 1 und 2 sind zwingend so zu verstehen, dass die erste Spannung $U_1$ an einem Ausgang einer ersten Detektionseinheit (nicht in Fig. 1 gezeigt) anliegt, wobei diese Detektionseinheit zum Erfassen eines ersten Stroms dient, welcher einem Elektromotor zugeführt wird, so dass die an dem Ausgang der ersten Detektionseinheit anliegende Spannung vom erfassten ersten Strom abhängt; und wobei ferner dieser Ausgang der ersten Detektionseinheit mit dem ersten Eingang $IN_1$ des Differenzspannungsmessers 131 verbunden ist und hierdurch die erste Spannung $U_1$ an den ersten Eingang $IN_1$ des Differenzspannungsmessers 131 angelegt ist.

Es sei im Folgenden ohne Einschränkung angenommen, dass der erste Eingang $IN_1$ des Differenzspannungmesssers **131** der negative Eingang ist, und dass der zweite Eingang $IN_2$ des Differenzspannungsmesser der positive Eingang ist.

Zu Beginn der Spannungsmessung steuert der Mikrocontroller 130 die Schalteinheit 110 derart an, dass das bekannte Spannungspotential $U_B$ am zweiten Eingang des Differenzspannungsmessers anliegt. Dies entspricht Schritt 210 des in Fig. 2 dargestellten Verfahren. Der Differenzspannungmesser misst nun gemäß Schritt 211 eine erste Differenzspannung $U_{D,1}= U_B - U_1$. Aus dieser ersten Differenzspannung kann der Mikrocontroller die Spannung $U_1$ gemäß Schritt 212 wie folgt bestimmen: $U_1=U_B-U_{D,1}$

Es kann besonders vorteilhaft sein, die bekannte Spannung $U_B$ auf Massepotential zu legen, d.h. $U_B=0V$, da somit der Mikrocontroller die zu messende Spannung $U_1$ direkt aus der gemessenen ersten Differenzspannung $U_{D,1}$ ohne Berechnungen bestimmen kann.

Nachfolgend steuert der Mikrocontroller die Schalteinheit 110 derart an, dass die zweite Spannung $U_2$ am zweiten Eingang des Differenzspannungsmessers anliegt. Dies entspricht Schritt 213 des in Fig. 2 dargestellten Flussdiagramms. Der Differenzspannungsmesser 131 misst nun eine zweite Differenzspannung $U_{D,2} = U_2 - U_1$ entsprechend Schritt 214.

Der Mikrocontroller 130 kann nun beispielsweise in Schritt 215 überprüfen, ob die zweite gemessene Differenzspannung $U_{D,2}$ oberhalb eines Grenzwertes $U_L$ liegt. Diese Überprüfung kann beispielsweise dazu eingesetzt werden, um zu kontrollieren ob die zweite gemessene Differenzspannung $U_{D,2}$ im zulässigen Messbereichs des Differenzspannungsmessers 131 liegt. Erkennt der Mikrocontroller in Schritt 215 z.B. eine Spannungsüberschreitung, so beginnt das Verfahren der Spannungsmessung wieder bei Schritt 210. Die Messwiederholung erfolgt so lange bis keine Spannungsüberschreitung in Schritt 215 festgestellt wird. Somit kann verhindert werden, dass durch Überschreitung des zulässigen Messbereichs des Differenzspannungsmessers 131 die Messung verfälscht wird.

Liegt keine Spannungsüberschreitung in Schritt 215 vor, so bestimmt der Mikrocontroller 130 aus der zuvor bestimmten ersten Spannung $U_1$ und der gemessenen zweiten Differenzspannung $U_{D,2}$ die zweite Spannung wie folgt:

$$U_2 = U_{D,2} + U_1$$

Somit können mit der erfindungsgemäßen Vorrichtung nach Fig. 1 und des erfindungsgemäßen Verfahren nach Fig. 2 zwei Spannungen mit nur einem Differenzspannungsmesser 131 gemessen werden, wobei die erste Spannung $U_1$ an dem Ausgang der ersten Detektionseinheit (nicht in Fig. 1 gezeigt) anliegt, wobei diese Detektionseinheit zum Erfassen eines ersten Stroms dient, welcher dem Elektromotor zugeführt wird. Ferner ermöglicht diese erfindungsgemäße Messung das Ausnutzen des kompletten Messbereichs des Differenzspannungsmessers 131.

Der Differenzspannungsmesser 131 kann z.B. durch einen Sigma Delta AD-Wandler realisiert werden. Das Entkopplungselement 120 dient zur Entkopplung der Schalteinheit 110 vom zweiten Eingang des Differenzspannungsmessers 131, und kann beispielsweise durch einen Widerstand realisiert werden. Das Entkopplungselement 120 kann jedoch auch weggelassen werden.

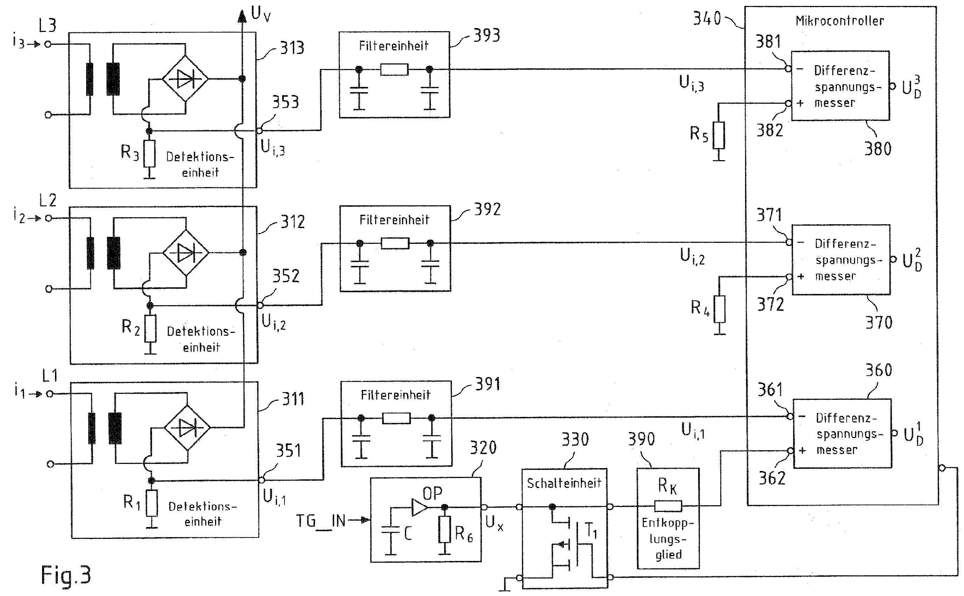

Das in Fig. 3 gezeigte Blockschaltbild zeigt ein weiteres Ausführungsbeispiel der vorliegenden Erfindung zur Erfassung von drei Phasenströmen $i_1, i_2, i_3$, welche einem Dreiphasenelektromotor zugeführt werden, durch einen Mikrocontroller **340**. Die in Fig. 3 gezeigte Anordnung kann beispielsweise in einem Motorschutzschalter angeordnet sein und dort die dem Motor zugeführten Ströme überwachen, so dass der Mikrocontroller **340** z.B. durch Auswerten der drei Phasenströme $i_1, i_2, i_3$ eine Überlast oder einen Kurzschlussstrom erkennen kann und dann eine Abschaltung des Motors durchführt.

Ferner erfasst der Mikrocontroller **340** eine weitere Spannung $U_x$, welche über dem Kondensator C abfällt und am Ausgang der thermischen Gedächtniseinheit **320** anliegt. Die Spannung $U_x$ ist hierbei ein Maß für die thermische Belastung des Elektromotors, d.h. der Kondensator C wirkt als thermisches Gedächtnis des Elektromotors. Die thermische Gedächtniseinheit **320** und damit der Kondensator wird so angesteuert, z.B. durch das Signal TG_IN, dass sich nach einer Abschaltung des Elektromotors, die z.B. durch eine von Mikrocontroller **340** detektierte Überlast erfolgen kann, der Kondensator C entlädt, so dass die verringernde Spannung $U_x$ dem Abkühlen des Elektromotors entspricht. Diese Entladung kann über einen Widerstand erfolgen (in Fig. 3 nicht gezeigt). Ferner befindet sich zwischen dem Kondensator C und dem Ausgang der thermischen Gedächtniseinheit **320** ein Operationsverstärker OP, welcher verhindert, dass der Kondensator C beispielsweise über die Schalteinheit entladen wird. Die Kondensatorspannung wird somit mittels des Operationsverstärkers OP und des Widerstands $R_6$ an den Ausgang der thermischen Gedächtniseinheit **320** gelegt. Der Mikrocontroller **340** erfasst die Spannung $U_x$ mit Hilfe der erfindungsgemäßen Messvorrichtung und kann beispielsweise ein erneutes Einschalten des Motor nach einer Abschaltung des Motors erst dann wieder zulassen, wenn die Spannung $U_x$ unter einen vordefinierten Pegel gefallen ist und der Elektromotor somit hinreichend abgekühlt ist. Hiermit kann verhindert werden, dass der Elektromotor nach einer Überlast-Auslösung durch ein zu schnelles Wiedereinschalten thermisch überlastet wird. Gleichzeitig wird durch das thermische Gedächtnis beim Eintreten einer Überlastung die Vorerwärmung des Elektromotors berücksichtigt. Damit kann der als thermisches Gedächtnis wirkende Kondensator C zusammen mit dem Mikrocontroller **340** den Rückbiegevorgang eines Bimetalls in einem Motorschutzschalter simulieren. Somit werden bei der erfindungsgemäßen Auslöseinheit keine Bimetalle benötigt.

Die erste Detektionseinheit 311 erfasst den ersten dem Elektromotor zugeführten positiven Strom $i_1$, so dass am Ausgang 351 der Detektionseinheit **311** eine negative Spannung $U_{i,1}$ anliegt, welche vom erfassten Strom $i_1$ abhängt. Solange der in der ersten Detektionseinheit **311** enthaltene Stromwandler nicht in Sättigung geht, ist die Spannung $U_{i,1}$ proportional zum erfassten Strom $i_1$. Der in der ersten Detektionseinheit **311** verwendete Stromwandler weist auf der Primärseite, d.h. auf der vom Strom $i_1$ durchflossenen Seite, nur eine geringe Windungsanzahl auf, während die Windungszahl auf der Sekundärseite wesentlich höher ist. Somit kann ein höherer primärseitiger Strom $i_1$ auf einen kleineren sekundärseitigen Strom transformiert werden. Das Wicklungszahlverhältnis kann vorzugsweise so ausgewählt werden, dass sich unabhängig vom jeweiligen primärseitig zu erfassenden Strombereich, der vom jeweils eingesetzten Elektromotor und dem Nennstrom des Elektromotors abhängt, sekundärseitig ein konstanter Strombereich ergibt. Somit muss die sekundärseitige Schaltung zur Stromerfassung nicht für jeden verschiedenen primärseitig zu erfassenden Strombereich neu dimensioniert werden. Wie in Fig. 3 gezeigt, umfasst die erste Detektioneinheit **311** einen Brückengleichrichter, durch den der transformierte Strom $i_1$ fliesst. Ein Ausgang des Brückengleichrichters generiert eine Versorgungsspannung $U_{v,1}$, während ein anderer Ausgang des Brückengleichrichters über einen Widerstand $R_1$ gegen Masse verbunden ist. Somit fliesst der transformierte und gleichgerichtete Strom $i_1$ durch den Widerstand $R_4$, so dass über dem Widerstand $R_4$ gegen Masse die negative Spannung $U_{i,1}$ abfällt, und diese negative Spannung $U_{i,1}$ am Ausgang **351** der ersten Detektionseinheit **311** anliegt.

Analog zur ersten Detektionseinheit **311** erfasst die zweite Detektionseinheit **312** den zweiten Phasenstrom $i_2$, so dass am Ausgang der zweiten Detektionseinheit **312** die von $i_2$ abhängige negative Spannung $U_{i,2}$ anliegt; und die dritte Detektionseinheit **313** erfasst den dritten Phasenstrom $i_3$, so dass am Ausgang der dritten Detektionseinheit **313** die von $i_3$ abhängige negative Spannung $U_{i,3}$ anliegt. Die zweite Detektionseinheit **312** und die dritte Detektionseinheit **313** entsprechen vom Aufbau her der zuvor beschriebenen ersten Detektionseinheit **311**.

Diese drei ausgegebenen negativen Spannungen $U_{i,1}, U_{i,2}, U_{i,3}$ stellen somit Messgrößen für die dem Motor zugeführten Phasenströme $i_1, i_2, i_3$ dar.

Der Mikrocontroller **340** umfasst drei Differenzspannungsmesser **360, 370, 380,** wobei diese Differenzspannungsmesser **360, 370, 380** beispielsweise jeweils durch einen Sigma Delta AD Wandler realisiert werden können.

Der Ausgang der ersten Detektionseinheit **351** ist mit dem negativen Eingang **361** des ersten Differenzspannungsmesser **360** verbunden, so dass am negativen Eingang **361** des ersten Differenzspannungsmesser **360** die negative Spannung $U_{i,1}$ anliegt. Ferner ist der positive Eingang **362** des ersten Differenzspannungsmessers **360** über das Entkopplungsglied **390,** das in diesem Beispiel durch den Widerstand $R_k$ realisiert ist, mit der Schalteinheit verbunden.

Die Schalteinheit umfasst den Transistor $T_1$, wobei der Transistor $T_1$ in einem ersten Zustand leitend ist und hierbei das Massepotential über das Entkopplungsglied **390** an den positiven Eingang **362** des ersten Differenzspannungsmessers **360** leitet. In einem zweiten Zustand ist der Transistor $T_1$ nichtleitend, so dass die Spannung $U_x$ über das Entkopplungsglied **390** an den positiven Eingang **362** des ersten Differenzspannungsmessers **360** geschaltet wird. Der Transistor $T_1$ ist über eine Steuerleitung mit dem Mikrocontroller **340** verbunden, so dass der Mikrocontroller **340** den Transistor $T_1$ über diese Steuerleitung entweder in den ersten oder in den zweiten Zustand ansteuern kann, womit entweder das Massepotential oder die Spannung $U_x$ an den positiven Eingang **362** des ersten Differenzpannungsmessers **360** angelegt wird.

Mit Hilfe des erfindungsgemäßen Messverfahrens kann der erste Differenzspannungsmesser **360** sowohl die erste Spannung $U_{i,1}$, als auch die zweite Spannung $U_x$ messen. Dieses Messverfahren wird im Folgenden unter Einbeziehung der Fig. 2, in der ein Ablaufdiagramm des Messverfahrens dargestellt ist, erläutert, wobei die in diesem Ausführungsbeispiel verwendete erste Spannung $U_{i,1}$ der Spannung $U_1$ in Fig. 2 entspricht, und ferner die zweite Spannung $U_x$ der Spannung $U_2$ in Fig. 2 entspricht.

Der Mikrocontroller **340** steuert den Transistor $T_1$ über die Steuerleitung zunächst in den ersten Zustand an, so dass der Transistor $T_1$ leitet und das Massepotential am positiven Eingang **362** des ersten Differenzspannungsmessers **360** anliegt. Damit wird gemäß Schritt **210** ein bekanntes Spannungspotential, d.h. in diesem Ausführungsbeispiel das Massepotential, an den zweiten Eingang **362,** d.h. den negativen Eingang, des ersten Differenzspannungsmesser **360** angelegt. Gemäß Schritt **211** misst der erste Differenzspannungsmesser **360** nun die erste Differenzspannung

$$U_{D,1}^1 = 0V - U_{i,1}\,.$$ Da das bekannte Spannungspotential das Massepotential ist, kann der Mikrocontroller **340** aus der gemessenen ersten Differenzspannung $U_{D,1}^1$ gemäß Schritt **212** direkt die Spannung $U_{i,1}$ bestimmen.

Ferner ist die gemessene erste Differenzspannung $U_{D,1}^1$ positiv, weil die Spannung $U_{i,1}$ ein negatives Vorzeichen aufweist.

Somit kann die negative Spannung $U_{i,1}$ mit einfachen Mitteln gemessen werden, während bei Verwendung eines Mikrocontroller mit AD-Wandlern ohne Differenzeingängen, bei denen sich die einfachen Eingänge auf GND beziehen würden, die zu messende negative Spannung $U_{i,1}$ mit erhöhtem schaltungstechnischen Aufwand in eine positive Spannung konvertiert werden müsste.

Die gemessene erste Differenzspannung $U_{D,1}^1$ ist ferner proportional zum ersten Phasenstrom $i_1$, solange der Stromwandler in der ersten Detektionseinheit **311** nicht in Sättigung geht. Somit kann der Mikrocontroller **340** über die gemessene erste Differenzspannung $U_{D,1}^1$ den ersten Phasenstrom $i_1$ erfassen.

Nach Bestimmung der Spannung $U_{i,1}$ schaltet der Mikrocontroller **340** den Transistor $T_1$ in den zweiten Zustand, d.h. der Transistor $T_1$ sperrt, so dass gemäß Schritt **213** die Spannung $U_x$ am positiven Eingang **362** des ersten Differenzspannungsmessers **360** anliegt. Die Spannung $U_{i,1}$ liegt weiterhin am negativen Eingang **361** des ersten Differenzspannungsmessers **360** an. Gemäß Schritt **214** misst der erste Differenzspannungsmesser **360** nun die zweite Differenzspannung

$$U_{D,2}^{l} = U_x - U_{i,1} \; .$$

Der Mikrocontroller **340** prüft nun gemäß Schritt **215** nach, ob die zweite gemessene Differenzspannung $U_{D,2}^{l}$ einen vorbestimmten Grenzwert $U_L$ überschreitet. Mit dieser Prüfung kann der Mikrocontroller **340** überprüfen, ob die Spannung $U_{D,2}^{l}$ im zulässigen Messbereich des ersten Differenzspannungsmessers **360** liegt. Der Grenzwert $U_L$ ist somit in Abhängigkeit des Messbereichs des ersten Differenzspannungsmessers **360** zu wählen. Überschreitet die zweite gemessene Differenzspannung $U_{D,2}^{l}$ den vorbestimmten Grenzwert $U_L$, so beginnt der Mikrocontroller **340** den gesamten Messvorgang von vorne, d.h. der Mikrocontroller **340** schaltet gemäß Schritt **210** den Transistor $T_1$ in den ersten Zustand, so dass das Massepotential am positiven Eingang des ersten Differenzspannungsmessers **360** anliegt und die erste Differenzspannung $U_{D,1}^{l}$ gemessen wird. Die Schritte **210** bis **215** werden hierbei vom Mikrocontroller **340** solange wiederholt, bis die zweite gemessene Differenzspannung $U_{D,2}^{l}$ nicht mehr den vorbestimmten Grenzwert $U_L$ überschreitet. Überschreitet die zweite gemessene Differenzspannung $U_{D,2}^{l}$ nicht den Grenzwert $U_{D,2}^{l}$, d.h. liegt kein Überlauf des ersten Differenzspannungsmessers **360** vor, so kann der Mikrocontroller **340** gemäß Schritt **216** die zweite Spannung $U_x$, die im Flussdiagramm in Fig. 2 als $U_2$ bezeichnet ist, aus der bereits in Schritt **212** bestimmten Spannung $U_{i,1}$ wie folgt bestimmen:

$$U_x = U_{D,2}^{l} + U_{i,1}$$

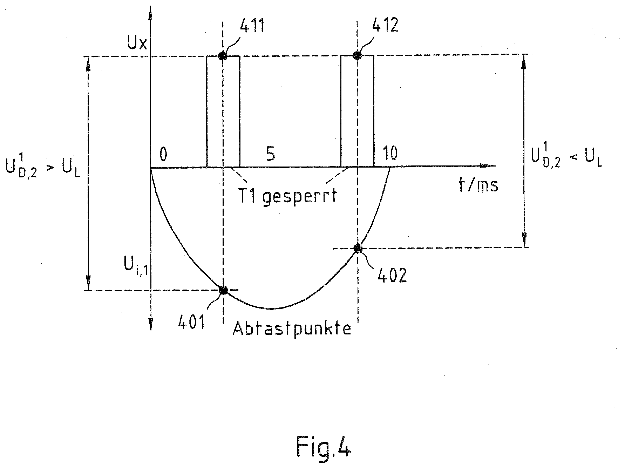

Fig. 4 zeigt diese Messwiederholung anhand eines exemplarischen Spannungsdiagramms, in dem der zeitliche Spannungsverlauf der negativen ersten Spannung $U_{i,1}$ und die zweite Spannung $U_x$ dargestellt ist. Zur Übersichtlichkeit sind in diesem Spannungsdiagramm nur die Abtastpunkte **401, 411** und **402, 412** zur Messung der zweiten gemessenen Differenzspannung $U_{D,2}^{l}$ dargestellt. Bei der ersten Messung der zweiten Differenzspannung $U_{D,2}^{l}$ mittels der Abtastpunkte **401** und **411**, wozu der Transistor $T_1$ vom Mikrocontroller **340** gesperrt wird, so dass die Spannung $U_x$ am zweiten Eingang **362** des ersten Differenzspannungsmessers **360** anliegt, liegt die gemessene zweite Differenzspannung

$U_{D,2}^{l}$ oberhalb des vorgegebenen Grenzwertes $U_L$, d. h. es liegt eine Überschreitung des Messbereichs des ersten Differenzspannungsmessers **360** vor. Dies wird vom Mikrocontroller **340** in Schritt **215** erkannt, und die Spannungsmessung beginnt von vorne bei Schritt **210** zur erneuten Messung der ersten Differenzspannung $U_{D,1}^{l}$ (nicht in Fig. 4 gezeigt). Nach der erneuten Messung der zweiten Differenzspannung $U_{D,2}^{l}$ in Schritt **214,** in Fig. 4 durch die Abtastpunkte **402** und **412** visualisiert, wird wiederum vom Mikrocontroller 340 gemäß Schritt **215** überprüft, ob eine Überschreitung der zweiten Differenzspannung $U_{D,2}^{l}$ vorliegt. Da die in Fig. 4 gemessene zweite Differenzspannung $U_{D,2}^{l}$ unterhalb des Grenzwertes $U_L$ liegt, fährt der Mikrocontroller 340 fort mit der Bestimmung der zweiten Spannung $U_x$ (in Schritt **216** als Spannung $U_2$ bezeichnet). In Bezug auf Fig. 4 sei ferner angemerkt, dass diese Figur nicht maßstabsgetreu ist, so erfolgt z.B. die Messung der ersten Differenzspannung $U_{D,1}^{l}$ und die nachfolgenden zweiten Differenzspannung $U_{D,2}^{l}$ in einem zeitlich sehr kurzen Abstand, da sich ansonsten die erste Spannung $U_{i,1}$ zwischen den beiden Messungen zu stark ändern würde und damit die Messung verfälschen würde.

Des Weiteren ist der Ausgang der zweiten Detektionseinheit **312** mit dem negativen Eingang **371** des zweiten Differenzspannungsmessers **370** verbunden, und der Ausgang der dritten Detektionseinheit **313** ist mit dem negativen Eingang **381** des dritten Differenzspannungsmessers 380 verbunden. Der positive Eingang **372** des zweiten Differenzspannungsmessers 370 und der positive Eingang **382** des dritten Differenzspannungsmessers **380** ist jeweils über einen Widerstand $R_4$, $R_5$ mit Masse verbunden. Somit ist die vom zweiten Differenzspannungsmesser **370** gemessene Spannung $U_D^2 = -U_{i,2}$ direkt proportional zum zweiten Phasenstrom $i_2$, und die vom dritten Differenzspannungsmesser **380** gemessene Spannung $U_D^3 = -U_{i,3}$ ist direkt proportional zum dritten Phasenstrom $i_3$, solange die Stromwandler der zweiten bzw. dritten Detektionseinheit **312, 313** nicht in Sättigung gehen.

Zwischen dem negativen Eingang **361** des ersten Differenzspannungsmessers **360** und dem Ausgang **351** der ersten Detektionseinheit **311** kann sich ferner eine Filtereinheit **391** befinden. Diese Filtereinheit **391** kann beispielsweise durch einen Tiefpass realisiert werden, wodurch höherfrequente Anteile der am Ausgang der ersten Detektionseinheit Spannung $U_{i,1}$ gedämpft werden und somit Störungen beim Spannungsmessen mittels des ersten Differenzspannungsmessers **360** vermieden werden können. Diese Filtereinheit **391** kann beispielsweise durch zwei Kondensatoren und einen Widerstand realisiert werden, wie in Fig. 2 gezeigt, es können jedoch auch andere Realisierungsformen gewählt werden. Ferner kann sich eine solche Filtereinheit **391, 392, 393** ebenso zwischen dem Ausgang der zweiten Detektionseinheit **312** und dem negativen Eingang **371** des zweiten Differenzspannungsmessers **370** befinden, wie auch zwischen dem Ausgang **313** der dritten Detektionseinheit **353** und dem negativen Eingang **381** des dritten Differenzspannungsmessers **380.**

Mit Hilfe der erfindungsgemäßen Messvorrichtung und des erfindungsgemäßen Messverfahrens können somit vier verschiedene Spannungen $U_{i,1}, U_{i,2}, U_{i,3}, U_x$ mit nur drei Spannungsmessern **360, 370, 380** erfasst werden, so dass kostengünstige Mikrocontroller **340** mit lediglich drei Spannungsmessern **360, 370, 380** verwendet werden können. Somit kann die vorliegende Erfindung zur kostengünstigen Realisierung eines elektronischen Motorschutzschalters verwendet werden.

Ferner ermöglicht die vorliegende Erfindung eine weitgehende Ausnutzung des Messbereichs des ersten Differenzspannungsmessers **360** bei der Ermittlung der Spannungen $U_{i,1}$ und $U_x$.

Ein weiterer Vorteil der vorliegenden Erfindung liegt in der effizienten Erfassung der drei negativen Spannungen $U_{i,1}, U_{i,2}, U_{i,3}$, welche jeweils am negativen Eingang des zugeordneten Differenzspannungsmessers **360, 370, 380** anliegen, und somit trotz ihres negativen Vorzeichens direkt und ohne aufwändige Konverterschaltungen, die z.B. mindestens einen Operationsverstärker enthalten würden, gemessen werden können.

**Patentansprüche**

1. Verfahren zur Messung einer ersten Spannung und einer zweiten Spannung mit einem Differenzspannungsmesser (131, 360), wobei der Differenzspannungsmesser (131, 360) einen ersten Eingang, und einen zweiten Eingang umfasst, und wobei die erste Spannung an einem Ausgang einer ersten Detektionseinheit (311) anliegt, und diese erste Detektionseinheit (311) zum Erfassen eines ersten Stroms dient, welcher einem Elektromotor, insbesondere einem Wechselstrommotor, zugeführt wird, so dass die an dem Ausgang der ersten Detektionseinheit (311) anliegende Spannung vom erfassten ersten Strom abhängt; und wobei ferner der Ausgang der ersten Detektionseinheit (311) mit dem ersten Eingang des Differenzspannungsmessers (131, 360) verbunden ist und hierdurch die erste Spannung an den ersten Eingang des Differenzspanungsmessers (131, 360) angelegt ist, wobei das Verfahren die folgenden Schritte umfasst:

- (210) Anlegen eines bekannten Spannungspotentials an den zweiten Eingang des Differenzspannungsmessers (131, 360);
- (211) Messen einer ersten Differenzspannung;
- (212) Bestimmen der ersten Spannung aus der gemessenen ersten Differenzspannung und dem bekannten Spannungspotential;
- (213) Anlegen der zweiten Spannung an den zweiten Eingang des Differenzspannungsmessers (131, 360);
- (214) Messen einer zweiten Differenzspannung während die erste Spannung am ersten Eingang des Differenzspannungsmessers (131, 360) angelegt ist; und
- (216) Bestimmen der zweiten Spannung aus der gemessenen zweiten Differenzspannung und der vorher bestimmten ersten Spannung.

2. Verfahren nach Anspruch 1, wobei nach dem Messen der zweiten Differenzspannung geprüft wird (215), ob die zweite Differenzspannung einen vorbestimmtem Grenzwert überschreitet, und das Messverfahren bei Überschreitung des vorbestimmten Grenzwertes wieder von vorne beginnt, wobei das Messverfahren so lange wiederholt wird (210-215), bis die zweite gemessene Differenzspannung den vorbestimmten Grenzwert nicht überschreitet, und erst dann die zweite Spannung aus der gemessenen zweiten Differenzspannung und der vorher bestimmten ersten Spannung bestimmt wird (216).

3. Verfahren nach einem der Ansprüche 1 bis 2, wobei eine Schalteinheit (110, 330) an den zweiten Eingang das Differenzspannungsmesser (131, 360) angeschlossen ist, derart, dass die Schalteinheit (110, 330) in einem ersten Zustand das bekannte Spannungspotential an den zweiten Eingang des Differenzspannungsmessers schaltet, und dass die Schalteinheit (110, 330) in einem zweiten Zustand die zweite Spannung an den zweiten Eingang des Differenzspannungsmesser schaltet; und wobei die Schalteinheit (110, 330) zur Messung der ersten Differenzspannung in den ersten Zustand angesteuert wird, und nachfolgend die Schalteinheit (110, 330) zur Messung der zweiten Differenzspannung in den zweiten Zustand angesteuert wird.

4. Verfahren nach Anspruch 3, wobei der vorzugsweise als Sigma Delta AD Wandler gebildete Differenzspannungsmesser (131, 360) in einem Mikrocontroller (130, 340) angeordnet ist, und wobei das Messverfahren durch den Mikrocontroller (130, 340) ausgeführt wird, und insbesondere die vorzugsweise durch einen Transistor gebildete Schalteinheit (110, 330) durch den Mikrocontroller gesteuert wird.

5. Vorrichtung zur Messung einer ersten Spannung und einer zweiten Spannung umfassend eine Schalteinheit (110, 330) und einen Mikrocontroller (130, 340), der einen Differenzspannungsmesser enthält (131, wobei die erste Spannung an einem ersten Eingang des Differenzspannungsmessers (131, 360) anliegt; und wobei die Schalteinheit (110, 330) an den zweiten Eingang des Differenzspannungsmesser (131, 360) angeschlossen ist, derart, dass die Schalteinheit (110, 330) in einem ersten Zustand ein bekanntes Spannungspotential an den zweiten Eingang des Differenzspannungsmessers (131, 360) schaltet, und dass die Schalteinheit (110, 330) in einem zweiten Zustand die zweite Spannung an den zweiten Eingang des Differenzspannungsmesser (131, 360) schaltet während die erste Spannung am ersten Eingang des Differenzspannungsmessers (131, 360) anliegt; wobei die Vorrichtung eine erste Detektionseinheit (311) umfasst, und diese erste Detektionseinheit (311) zum Erfassen eines ersten Stroms dient, welcher einem Elektromotor, insbesondere einem Wechselstrommotor, zugeführt wird, so dass die an einem Ausgang der ersten Detektionseinheit (311) anliegende Spannung vom erfassten ersten Strom abhängt, wobei die an dem Ausgang der ersten Detektionseinheit (311) anliegende Spannung die erste Spannung darstellt, und wobei ferner dieser Ausgang mit dem ersten Eingang des Differenzspannungsmessers (131, 360) verbunden ist; und wobei der Mikrocontroller (130, 340) die folgenden Schritte ausführt:

- Ansteuern der Schalteinheit (110, 330) in den ersten Zustand;
- Einlesen einer vom Differenzspannungsmesser (131, 360) gemessenen ersten Differenzspannung;
- Bestimmen der ersten Spannung aus der gemessenen ersten Differenzspannung und dem bekannten, vorzugsweise durch das Massepotential gebildeten Spannungspotential;
- Ansteuern der Schalteinheit (110, 330) in den zweiten Zustand;
- Einlesen einer vom Differenzspannungsmesser (131, 360) gemessenen zweiten Differenzspannung; und
- Bestimmen der zweiten Spannung aus der gemessenen zweiten Differenzspannung und der vorher bestimmten ersten Spannung bestimmt.

6. Vorrichtung nach Anspruch 5, wobei der Mikrocontroller (130, 340) nach dem Messen der zweiten Differenzspannung prüft, ob die zweite Differenzspannung einen vorbestimmtem Grenzwert überschreitet, und der Mikrocontroller (130, 340) die Messung bei Überschreiten des vorbestimmten Grenzwertes wieder von vorne beginnt, wobei der Mikrocontroller (130, 340) die Messung so lange wiederholt, bis die zweite Differenzspannung den vorbestimmten Grenzwert nicht überschreitet, und dann erst dann der Mikrocontroller (130, 340) die zweite Spannung aus der gemessenen zweiten Differenzspannung und der vorher bestimmten ersten Spannung bestimmt.

7. Vorrichtung nach einem der Ansprüche 5 oder 6, wobei der erste Eingang des Differenzspannungsmessers (131, 360) der negative Eingang des Differenzspannungsmessers (131, 360) ist, und der zweite Eingang des Differenzspannungsmessers (131, 360) der positive Eingang des Differenzspannungsmessers (131, 360) ist.

8. Vorrichtung nach einem der Ansprüche 5 bis 7, wobei zwischen der Schalteinheit (110, 330) und dem zweiten Eingang des Differenzspannungsmessers (131, 360) ein Entkopplungsglied (120, 390) platziert ist.

9. Vorrichtung nach einem der Ansprüche 5 bis 8, wobei der Mikrocontroller (130, 340) mindestens einen weiteren Spannungsmesser (370, 380) umfasst.

10. Vorrichtung nach einem der Ansprüche 5 bis 9, wobei die zweite Spannung an einem Kondensator anliegt, und der Kondensator mit der Schalteinheit (330), vorzugsweise über einen Operationsverstärker verbunden ist, und wobei der Kondensator ein thermisches Gedächtnis für vorhergehende thermische Abschaltungen des Elektromotors darstellt.

11. Vorrichtung nach einem der Ansprüche 5 bis 10, wobei zwischen dem Ausgang der Detektionseinheit (311) und dem ersten Eingang des Differenzspannungsmessers (360) eine Filtereinheit (391) platziert ist.

12. Vorrichtung nach einem der Ansprüche 5 bis 11, wobei der Elektromotor ein Wechselstrommotor ist, und der erste Strom einen ersten Phasenstrom darstellt.

13. Vorrichtung nach Anspruch 12, wobei die erste Detektionseinheit (311) folgende Mittel umfasst:

- einen Stromwandler, durch dessen Primärseite der zu erfassende Phasenstrom fließt; und
- einen Gleichrichter, welcher an dem sekundärseitigen Ausgang des Stromwandlers angeschlossen ist zum Gleichrichten des transformierten Phasenstroms, wobei der Gleichrichter vorzugsweise ein Brückengleichrichter ist, und ein zweiter Ausgang des Brückengleichrichters eine Versorgungsspannung generiert; und
- einen Widerstand, der zwischen dem Gleichrichter und einem Massepunkt angeschlossen ist, derart, dass der transformierte und gleichgerichtete Phasenstrom durch den Widerstand fließt und über dem Widerstand eine Spannung abfällt, und diese Spannung an dem Ausgang (351) der Detektionseinheit (311) anliegt.

14. Vorrichtung nach Anspruch 13, wobei dem Elektromotor mindestens ein weiterer Phasenstrom zugeführt wird, und jedem des mindestens einen weiteren Phasenstroms jeweils eine weitere Detektionseinheit (312, 313) und jeweils ein im Mikrocontroller (340) angeordneter Spannungsmesser (370, 380) zugeordnet ist, wobei jede dieser mindestens einen weiteren Detektionseinheit (312, 313) der ersten Detektionseinheit (311) entspricht, so dass jeweils am Ausgang dieser mindestens einen weiteren Detektionseinheit (312, 313) eine Spannung anliegt, welche vom jeweils zugeordneten und erfassten Phasenstrom abhängt; und wobei ferner jeder Ausgang (352, 353) dieser mindestens einen weiteren Detektionseinheit (312, 313) mit einem ersten Eingang des jeweils zugeordneten Spannungsmessers (370, 380) verbunden ist.

15. Vorrichtung nach Anspruch 14, wobei zwischen mindestens einem Ausgang (352, 353) der mindestens einen weiteren Detektionseinheit (312, 313) und dem ersten Eingang des jeweils zugeordneten Spannungsmesser (370, 380) eine Filtereinheit (392, 393) platziert ist.

16. Vorrichtung nach Anspruch 15, wobei mindestens einer des mindestens einen Spannungsmessers (370, 380) ein Sigma Delta AD Wandler ist, und ein zweiter Eingang dieses mindestens einen Sigma Delta AD Wandlers mit Masse verbunden ist, und wobei der erste Eingang des mindestens einen Sigma AD Wandlers der negative Eingang ist, und der zweite Eingang des mindestens einen Sigma Delta AD Wandlers der positive Eingang ist.

17. Vorrichtung nach einem der Ansprüche 5 bis 16, wobei der Mikrocontroller (130, 340) und die mindestens eine Detektionseinheit in einem Motorschutzschalter angeordnet sind.

**Claims**

1. Method for measuring a first voltage and a second voltage with a differential voltmeter (131, 360), wherein the differential voltmeter (131, 360) comprises a first input and a second input, and wherein the first voltage is present at an output of a first detection unit (311), and this first detection unit (311) serves to detect a first current which is supplied to an electric motor, in particular an AC motor, so that the voltage present at the output of the first detection unit (311) depends upon the detected first current; and wherein furthermore the output of the first detection unit (311) is connected to the first input of the differential voltmeter (131, 360) and as a result the first voltage is applied to the first input of the differential voltmeter (131, 360), wherein the method comprises the following steps:

- (210) applying a known voltage potential to the second input of the differential voltmeter (131, 360);
- (211) measuring a first differential voltage;
- (212) determining the first voltage from the measured first differential voltage and the known voltage potential;
- (213) applying the second voltage to the second input of the differential voltmeter (131, 360);
- (214) measuring a second differential voltage whilst the first voltage is applied to the first input of the differential voltmeter (131, 360); and
- (216) determining the second voltage from the measured second differential voltage and the previously determined first voltage.

2. Method according to claim 1, wherein after measurement of the second differential voltage a check is performed (215) as to whether the second differential voltage exceeds a predetermined limit value, and the measurement method starts again from the beginning if the predetermined limit value is exceeded, wherein the measurement method is repeated (210-215) until the second measured differential voltage does not exceed the predetermined limit value, and only then the second voltage is determined (216) from the measured second differential voltage and the previously determined first voltage.

3. Method according to any of claims 1 to 2, wherein a switch unit (110, 330) is connected to the second input the differential voltmeter (131, 360) in such a way that in a first state the switch unit (110, 330) switches the known voltage potential to the second input of the differential voltmeter, and that in a second state the switch unit (110, 330) switches the second voltage to the second input of the differential voltmeter;

and wherein the switch unit (110, 330) is activated into the first state for measurement of the first differential voltage, and then the switch unit (110, 330) is activated into the second state for measurement of the second differential voltage.

4. Method according to claim 3, wherein the differential voltmeter (131, 360) is preferably formed as a Sigma Delta AD converter and is arranged in a microcontroller (130, 340), and wherein the measurement method is carried out by the microcontroller (130, 340), and in particular the switch unit (110, 330), which is preferably formed by a transistor, is controlled by the microcontroller.

5. Device for measuring a first voltage and a second voltage, comprising a switch unit (110, 330) and a microcontroller (130, 340) which contains (131, 360) a differential voltmeter; wherein the first voltage is present at a first input of the differential voltmeter (131, 360); and wherein the switch unit (110, 330) is connected to the second input of the differential voltmeter (131, 360), in such a way that in a first state the switch unit (110, 330) switches a known voltage potential to the second input of the differential voltmeter (131, 360), and that in a second state the switch unit (110, 330) switches the second voltage to the second input of the differential voltmeter (131, 360) whilst the first voltage is present at the first input of the differential voltmeter (131, 360); wherein the device comprises a first detection unit (311), and this first detection unit (311) serves to detect a first current which is supplied to an electric motor, in particular an AC motor, so that the voltage present at an output of the first detection unit (311) depends upon the detected first current, wherein the voltage present at the output of the first detection unit (311) represents the first voltage, and wherein furthermore this output is connected to the first input of the differential voltmeter (131, 360); and wherein the microcontroller (130, 340) carries out the following steps:

   - activating the switch unit (110, 330) into the first state;
   - inputting a first differential voltage measured by the differential voltmeter (131, 360);
   - determining the first voltage from the measured first differential voltage and the known voltage potential preferably formed by the earth potential;
   - activating the switch unit (110, 330) into the second state;
   - inputting a second differential voltage measured by the differential voltmeter (131, 360);
   - and determining the second voltage from the measured second differential voltage and the previously determined first voltage.

6. Device according to claim 5, wherein after measurement of the second differential voltage the microcontroller (130, 340) checks whether the second differential voltage exceeds a predetermined limit value, and the microcontroller (130, 340) starts the measurement again from the beginning if the predetermined limit value is exceeded, wherein the microcontroller (130, 340) repeats the measurement until the second differential voltage does not exceed the predetermined limit value, and then only then the microcontroller (130, 340) determines the second voltage from the measured second differential voltage and the previously determined first voltage.

7. Device according to any of claims 5 or 6, wherein the first input of the differential voltmeter (131, 360) is the negative input of the differential voltmeter (131, 360), and the second input of the differential voltmeter (131, 360) is the positive input of the differential voltmeter (131, 360).

8. Device according to any of claims 5 to 7, wherein a decoupling element (120, 390) is placed between the switch unit (110, 330) and the second input of the differential voltmeter (131, 360).

9. Device according to any of claims 5 to 8, wherein the microcontroller (130, 340) comprises at least one further voltmeter (370, 380).

10. Device according to any of claims 5 to 9, wherein the second voltage is present at a capacitor, and the capacitor is connected to the switch unit (330), preferably by means of an operational amplifier, and wherein the capacitor constitutes a thermal memory for previous thermal disconnections of the electric motor.

11. Device according to any of claims 5 to 10, wherein a filter unit (391) is placed between the output of the detection unit (311) and the first input of the differential voltmeter (360).

12. Device according to any of claims 5 to 11, wherein the electric motor is an AC motor and the first current represents a first phase current.

13. Device according to claim 12, wherein the first detection unit (311) comprises the following means:

   - a current transducer in which the phase current to be detected flows through the primary side; and
   - a rectifier, which is connected to the secondary-side output of the current transducer for rectifying the transformed phase current, wherein the rectifier is preferably a bridge rectifier, and a second output of the bridge rectifier generates a supply voltage; and
   - a resistor, which is connected between the rectifier and an earth point in such a way that the transformed and rectified phase current flows through the resistor and a voltage drops over the resistor, and this voltage is present at the output (351) of the detection unit (311).

14. Device according to claim 13, wherein at least one further phase current is supplied to the electric motor, and in each case a further detection unit (312, 313) and in each case a voltmeter (370, 380) arranged in the microcontroller (340) is associated with each one of the at least one further phase current, wherein each one of this at least one further detection unit (312, 313) corresponds to the first detection unit (311), so that a voltage is present in each case at the output of this at least one further detection unit (312, 313) which is dependent on respective associated and detected phase current; and wherein furthermore each output (352, 353) of this at least one further detection unit (312, 313) is connected to a first input of the respective associated voltmeter (370, 380).

**15.** Device according to claim 14, wherein a filter unit (392, 393) is placed between at least one output (352, 353) of the at least one further detection unit (312, 313) and the first input of the respective associated voltmeter (370, 380).

**16.** Device according to claim 15, wherein at least one of the at least one voltmeter (370, 380) is a Sigma Delta AD converter, and a second input of this at least one Sigma Delta AD converter is connected to earth, and wherein the first input of the at least one Sigma AD converter is the negative input, and the second input of the at least one Sigma Delta AD converter is the positive input.

**17.** Device according to any of claims 5 to 16, wherein the microcontroller (130, 340) and the at least one detection unit are arranged in a motor protection switch.

**Revendications**

**1.** Procédé de mesure d'une première tension et d'une seconde tension avec un dispositif de mesure de différence de tension (131, 360), dans lequel le dispositif de mesure de différence de tension (131, 360) comprend une première entrée et une seconde entrée et dans lequel la première tension s'applique à une sortie d'une première unité de détection (311) et cette première unité de détection (311) sert à détecter un premier courant qui est acheminé à un moteur électrique, en particulier à un moteur à courant alternatif de sorte que la tension s'appliquant à la sortie de la première unité de détection (311) dépende du premier courant détecté, et dans lequel, en outre, la sortie de la première unité de détection (311) est connectée à la première entrée du dispositif de mesure de différence de tension (131, 360), et, de ce fait, la première tension est appliquée à la première entrée du dispositif de mesure de différence de tension (131, 360), dans lequel le procédé comprend les étapes suivantes consistant à :

- (210) appliquer un potentiel de tension connu à la seconde entrée du dispositif de mesure de différence de tension (131, 360) ;

- (211) mesurer une première différence de tension ;
- (212) déterminer la première tension à partir de la première différence de tension mesurée et du potentiel de tension connu ;
- (213) appliquer la seconde tension à la seconde entrée du dispositif de mesure de différence de tension (131, 360) ;
- (214) mesurer une seconde différence de tension tandis que la première tension est appliquée à la première entrée du dispositif de mesure de différence de pression (131, 360) ; et
- (216) déterminer la seconde tension à partir de la seconde différence de tension mesurée et de la première tension précédemment déterminée.

**2.** Procédé selon la revendication 1, dans lequel, après la mesure de la seconde différence de tension, on teste (215) si la seconde différence de tension dépasse une valeur limite prédéterminée et le procédé de mesure recommence au début lors du dépassement de la valeur limite prédéterminée, dans lequel le procédé de mesure est répété (210-215) jusqu'à ce que la seconde différence de tension mesurée ne dépasse pas la valeur limite prédéterminée et ce n'est qu'ensuite que la seconde tension est déterminée (216) à partir de la seconde différence de tension mesurée et de la première tension précédemment déterminée.

**3.** Procédé selon l'une quelconque des revendications 1 à 2, dans lequel une unité de commutation (110, 330) est connectée à la seconde entrée le dispositif de mesure de différence de tension (131, 360) en sorte que l'unité de commutation (110, 330) commute, dans un premier état, le potentiel de tension connu à la seconde entrée du dispositif de mesure de différence de tension et que l'unité de commutation (110, 330) commute, dans un second état, la seconde tension à la seconde entrée du dispositif de mesure de différence de tension ; et dans lequel l'unité de commutation (110, 330) est commandée dans le premier état pour mesurer la première différence de tension et ensuite l'unité de commutation (110, 330) est commandée pour mesurer la seconde différence de tension dans le second état.

**4.** Procédé selon la revendication 3, dans lequel le dispositif de mesure de différence de tension (131, 360) conformé de préférence en convertisseur AD Sigma Delta est agencé dans un microcontrôleur (130, 340) et dans lequel le procédé de mesure est effectué par le microcontrôleur (130, 340) et, en particulier, l'unité de commutation (110, 330) formée de préférence par un transistor est commandée par le microcontrôleur.

**5.** Dispositif de mesure d'une première tension et d'une seconde tension comprenant une unité de commutation (110, 330) et un microcontrôleur (130, 340), qui contient (131, 360) un dispositif de mesure de différence de tension ; dans lequel la première tension s'applique à une première entrée du dispositif de mesure de différence de tension (131, 360) ; et dans lequel l'unité de commutation (110, 330) est connectée à la seconde entrée du dispositif de mesure de différence de tension (131, 360) de sorte que l'unité de commutation (110, 330) commute, dans un premier état, un potentiel de tension connu à la seconde entrée du dispositif de mesure de différence de tension (131, 360) et que l'unité de commutation (110, 330) commute la seconde tension à la seconde entrée du dispositif de mesure de différence de tension (131, 360) tandis que la première tension s'applique à la première entrée du dispositif de mesure de différence de tension (131, 360) ; dans lequel le dispositif comprend une première unité de détection (311) et cette première unité de détection (311) sert à détecter un premier courant qui est acheminé à un moteur électrique, en particulier à un moteur à courant alternatif de sorte que la tension appliquée à une sortie de la première unité de détection (311) dépend du premier courant détecté, dans lequel la tension appliquée à la sortie de la première unité de détection (311) représente la première tension et dans lequel, en outre, cette sortie est connectée à la première entrée du dispositif de mesure de différence de tension (131, 360) ; et dans lequel le microcontrôleur (130, 340) effectue les étapes suivantes consistant à :

- commander l'unité de commutation (110, 330) dans le premier état ;
- lire une première différence de tension mesurée par le dispositif de mesure de différence de tension (131, 360) ;
- déterminer la première tension à partir de la première différence de tension mesurée et du potentiel de tension connu formé de préférence par le potentiel de masse ;
- commander l'unité de commutation (110, 330) dans le second état ;
- lire une seconde différence de tension mesurée par le dispositif de mesure de différence de tension (131, 360) ; et
- déterminer la seconde tension à partir de la seconde différence de tension mesurée et de la première tension précédemment déterminée.

**6.** Dispositif selon la revendication 5, dans lequel le microcontrôleur (130, 340) teste après la mesure de la seconde différence de tension si la seconde différence de tension dépasse une valeur limite prédéterminée et le microcontrôleur (130, 340) recommence au début la mesure lors du dépassement de la valeur limite prédéterminée, dans lequel le microcontrôleur (130, 340) répète la mesure jusqu'à ce que la seconde différence de tension ne dépasse pas la valeur limite prédéterminée et ensuite ce n'est qu'ensuite que le microcontrôleur (130, 340) détermine la seconde tension à partir de la seconde différence de tension mesurée et de la première tension précédemment déterminée.

**7.** Dispositif selon l'une quelconque des revendications 5 ou 6, dans lequel la première entrée du dispositif de mesure de différence de tension (131, 360) est l'entrée négative du dispositif de mesure de différence de tension (131, 360) et la seconde entrée du dispositif de mesure de différence de tension (131, 360) est l'entrée positive du dispositif de mesure de différence de tension (131, 360).

**8.** Dispositif selon l'une quelconque des revendications 5 à 7, dans lequel un élément de découplage (120, 390) est placé entre l'unité de commutation (110, 330) et la seconde entrée du dispositif de mesure de différence de tension (131, 360).

**9.** Dispositif selon l'une quelconque des revendications 5 à 8, dans lequel le microcontrôleur (130, 340) comprend au moins un autre dispositif de mesure de tension (370, 380).

**10.** Dispositif selon l'une quelconque des revendications 5 à 9, dans lequel la seconde tension s'applique à un condensateur et le condensateur est connecté à l'unité de commutation (330), de préférence via un amplificateur opérationnel, et dans lequel le condensateur représente une mémoire thermique pour des déconnexions thermiques précédentes du moteur électrique.

**11.** Dispositif selon l'une quelconque des revendications 5 à 10, dans lequel une unité de filtrage (391) est placée entre la sortie de l'unité de détection (311) et la première entrée du dispositif de mesure de différence de tension (360).

**12.** Dispositif selon l'une quelconque des revendications 5 à 11, dans lequel le moteur électrique est un moteur à courant alternatif et le premier courant représente un premier courant de phase.

**13.** Dispositif selon la revendication 12, dans lequel la première unité de détection (311) comprend les moyens suivants :

- un convertisseur de courant par le côté primaire duquel le courant de phase à détecter s'écoule ; et
- un redresseur qui est connecté à la sortie côté secondaire du convertisseur de courant pour redresser le courant de phase transformé, dans lequel le redresseur est de préférence un redresseur à pont et une seconde sortie du redresseur à pont génère une tension d'alimentation ; et

- une résistance qui est connectée entre le redresseur et un point massique de sorte que le courant de phase transformé et redressé s'écoule par la résistance et qu'une tension diminue via la résistance, cette tension étant appliquée à la sortie (351) de l'unité de détection (311).

14. Dispositif selon la revendication 13, dans lequel est acheminé au moteur électrique au moins un autre courant de phase et à chacun du au moins un autre courant de phase est ou sont affectés, respectivement une autre unité de détection (312, 313) et respectivement un dispositif de mesure de tension (370, 380) agencé dans le microcontrôleur (340), dans lequel chacune de cette au moins une autre unité de détection (312, 313) correspond à la première unité de détection (311), de sorte que, respectivement, à la sortie de cette au moins une autre unité de détection (312, 313) s'applique une tension qui dépende du courant de phase respectivement affecté et détecté ; et dans lequel, en outre, chaque sortie (352, 353) de cette au moins une autre unité de détection (312, 313) est connectée à une première entrée du dispositif de mesure de tension respectivement affecté (370, 380).

15. Dispositif selon la revendication 14, dans lequel une unité de filtrage (392, 393) est placée entre au moins une sortie (352, 353) de la au moins une autre unité de détection (312, 313) et la première entrée du dispositif de mesure de tension respectivement affecté (370, 380).

16. Dispositif selon la revendication 15, dans lequel au moins l'un du au moins un dispositif de mesure de tension (370, 380) est un convertisseur AD Sigma Delta et une seconde entrée de ce au moins un convertisseur AD Sigma Delta est connectée à la masse et dans lequel la première entrée du au moins un convertisseur AD Sigma est l'entrée négative et la seconde entrée du au moins un convertisseur AD Sigma Delta est l'entrée positive.

17. Dispositif selon l'une quelconque des revendications 5 à 16, dans lequel le microcontrôleur (130, 340) et la au moins une unité de détection sont agencés dans un disjoncteur-protecteur.

Fig.1

Anlegen eines bekannten
Spannungspotentials an den
zweiten Eingang des
Differenzspannungsmessers — 210

Messung $U_{D,1}$ — 211

Bestimmung von $U_1$ — 212

Anlegen von $U_2$ an den
zweiten Eingang des
Differenzspannungsmessers — 213

Messung $U_{D,2}$ — 214

$U_{D,2} > U_L$    JA
— 215

NEIN

Bestimmung von $U_2$ — 216

Fig.2

Fig.3

Fig.4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1130405 A1